**Europäisches Patentamt**

**European Patent Office**

**Office européen des brevets**

(19)

(11) Numéro de publication : **0 374 060 B1**

(12)

# FASCICULE DE BREVET EUROPEEN

(45) Date de publication du fascicule du brevet :
**20.05.92 Bulletin 92/21**

(51) Int. Cl.$^5$ : **B23K 15/00**

(21) Numéro de dépôt : **89420484.1**

(22) Date de dépôt : **07.12.89**

(54) **Machine sous vide de grand volume, et procédé pour sa réalisation.**

(30) Priorité : **08.12.88 FR 8816505**

(43) Date de publication de la demande :
**20.06.90 Bulletin 90/25**

(45) Mention de la délivrance du brevet :
**20.05.92 Bulletin 92/21**

(84) Etats contractants désignés :
**DE FR**

(56) Documents cités :
**US-A- 3 365 091**
**US-A- 4 677 273**
**"Schweisstechnische Fertigungsver-**
**fahren",Eichhorn,VDI-Verlag Gmbh,Düssel-**
**dorf 1983**

(73) Titulaire : **TECHNIQUES METALLURGIQUES**
**AVANCEES - TECHMETA**
**Lieudit Champ Corbet**
**F-74370 Metz Tessy (FR)**

(72) Inventeur : **Sommeria-Klein, Denis**
**Chemin du Crêt-Ru**
**F-74370 Metz Tessy (FR)**

(74) Mandataire : **de Beaumont, Michel**
**Cabinet Poncet 7, chemin de Tillier B.P. 317**
**F-74008 Annecy RP Cédex (FR)**

## Description

La présente invention concerne les machines sous vide généralement utilisées pour réaliser des interventions spéciales de haute technicité, par exemple par procédé de bombardements électroniques (soudage, fusion, évaporation...). Ces interventions peuvent également être appliquées à la polymérisation de matériaux composites, ou à d'autres applications qui nécessitent une absence totale de pollution.

Les pièces sur lesquelles on veut effectuer les travaux ou interventions spéciales sont introduites à pression atmosphérique dans une enceinte munie d'une ouverture obturable par une porte étanche. Les pièces sont mises en position, puis on obture l'ouverture par la porte étanche, et on fait le vide à l'intérieur de l'enceinte.

Les interventions sont effectuées à l'intérieur de l'enceinte par un appareillage tel que des canons à électrons, fixés sur un support mobile pouvant se déplacer par rapport à la pièce selon toutes les directions nécessaires pour positionner et orienter l'appareillage selon les travaux à effectuer. L'appareillage est pour cela supporté par un support interne d'appareillage, alors que la pièce est supportée par un support interne de pièce.

Lorsque l'on fait le vide à l'intérieur de l'enceinte, la pression atmosphérique s'exerce alors sur toute la surface de l'enceinte, et atteint, pour les grandes enceintes, des valeurs de contraintes très importantes. Ainsi, la paroi de l'enceinte, déjà soumise aux variations de la température ambiante qui entraînent des phénomènes de dilatation ou de contraction, est soumise à des variations considérables de contraintes de pression. Il en résulte de très importants phénomènes de variations dimensionnelles, très difficiles à éliminer.

Cependant, le travail à l'intérieur de l'enceinte nécessite une très grande précision de positionnement de l'appareillage par rapport à la pièce.

Dans les machines traditionnelles de grands volumes, les parois de l'enceinte sont réalisées en structures métalliques plus ou moins indéformables, c'est-à-dire présentant en elles-mêmes une grande rigidité. On construit pour cela des parois d'enceinte dont l'épaisseur est relativement importante, lesdites parois étant généralement planes. Les supports d'appareillages sont fixés soit directement à des renforts de la paroi, soit à des socles extérieurs par l'intermédiaire de pièces rigides traversant la paroi. Dans ce dernier cas, la paroi et les pièces rigides sont alors désolidarisées par l'intermédiaire de soufflets permettant les mouvements de la paroi sans perturber le positionnement des appareillages.

Dans ces machines traditionnelles, les parois de l'enceinte doivent comporter une rigidité certaine, pour être compatibles avec les traversées des supports indéformables de l'appareillage. Par la présence des soufflets de traversées, ces machines présentent des difficultés de nettoyage, difficultés qui sont peu compatibles avec les exigences de propreté : une qualité essentielle d'une machine sous vide est sa facilité de nettoyage.

Le document US-A-4 677 273 décrit une telle machine traditionnelle, comportant une enceinte dont les parois latérales à section rectangulaire présentent une épaisseur relativement importante. L'appareillage est tenu par un support interne d'appareillage, la pièce à traiter étant portée par un support de pièce interne. Ce document ne comporte aucun enseignement sur la façon d'éviter l'influence néfaste des déformations de la paroi d'enceinte.

Le document SCHWEISSTECHNISCHE FERTIGUNGSVERFAHREN, EICHHORN, VDI-VERLAG Gmbh, 1983, décrit également une telle machine traditionnelle, comportant une enceinte à section transversale rectangulaire dans laquelle est logé un système gantry du type décrit dans le document USA-4 677 273.

De telles structures connues, qui présentent déjà des inconvénients lorsque les enceintes sont de dimensions relativement faibles, par exemple selon un diamètre de un à deux mètres, deviennent totalement inapplicables pour réaliser des enceintes de grandes dimensions, c'est-à-dire présentant une section transversale dont le diamètre est supérieur à cinq mètres. En effet, il faut se rendre compte que, pour les interventions spéciales de haute technicité, on demande que le positionnement des appareillages soit effectué selon une précision de l'ordre de quelques centièmes de millimètres, sur toute la plage de variation de position de l'appareillage.

Le problème proposé par la présente invention est de concevoir une nouvelle structure de machine sous vide dans laquelle l'enceinte puisse avoir une grande dimension, par exemple une dimension supérieure à cinq mètres de diamètre en section transversale, et dans laquelle le support interne d'appareillage puisse garantir une précision de positionnement de l'ordre de quelques centièmes de millimètres. Selon l'invention, ce résultat doit être obtenu sans pour autant augmenter exagérément l'épaisseur de la paroi d'enceinte, ce qui, pour des enceintes de grandes dimensions, conduirait à des structures trop lourdes et économiquement inapplicables.

La difficulté est que, lors de la réalisation du vide, une paroi de grande dimension se déforme inévitablement sous l'effet de la pression interne.

Un autre problème que se propose de résoudre la présente invention est d'augmenter au maximum la place disponible dans l'enceinte, pour une même surface d'enceinte, permettant l'usinage de pièces de grandes dimensions. Il est en effet intéressant de réduire la surface de paroi d'enceinte, pour un même volume de pièce usinées, pour faciliter l'établissement et le maintien du vide à l'intérieur de l'enceinte.

Un autre but de l'invention est de concevoir une telle structure de machines de grandes dimensions qui puisse être au maximum réalisée en atelier, testée en atelier, puis transportée sur site en plusieurs éléments, de façon à éviter le déplacement de main d'oeuvre qualifiée sur le site à équiper.

Pour atteindre ces buts ainsi que d'autres, une machine sous vide selon la présente invention comprend :

– une paroi externe définissant une enceinte étanche munie d'une porte d'accès,

– un support interne de pièce, destiné à supporter une pièce sur laquelle on veut effectuer les travaux,

– un support interne d'appareillage pour supporter et positionner un ou plusieurs appareils assurant les travaux sur la pièce, ledit support interne comprenant des montants latéraux supportant des rails longitudinaux sur lesquels circulent des chariots portant deux poutres maintenues verticales,

– une poutre horizontale coulissant par ses extrémités sur les poutres maintenues verticales, et équipée d'un chariot mobile supportant les appareillages ;

– la paroi externe comprend une partie inférieure rigide comportant une face supérieure interne constituant une base d'appui commune pour le support interne de pièce et le support interne d'appareillage, et comportant une face inférieure externe constituant la surface inférieure d'appui de la machine ;

– la partie restante de paroi externe présente une forme cylindrique de section transversale arrondie en voûte ;

– la partie restante de paroi externe présente une résistance plus réduite et se raccorde de manière étanche à ladite partie inférieure ;

– les supports internes de pièce et d'outillage sont en contact de la seule partie inférieure de paroi externe, à l'exclusion de tout contact avec la partie restante de paroi externe ;

– les montants latéraux sont incurvés et épousent sensiblement la forme interne de paroi externe.

Un procédé de réalisation d'une machine sous vide selon l'invention fait l'objet de la revendication 8.

Grâce à cette structure, seule la partie inférieure de la paroi externe doit être constituée d'une structure rigide pratiquement indéformable, alors que tout le reste de la paroi externe peut être constitué d'une paroi plus fine, admettant des déformations non négligeables sous l'effet des pressions ou des dilatations thermiques, sans que ces déformations aient une quelconque influence sur la précision de positionnement des appareillages par rapport aux pièces sur lesquelles on veut effectuer les travaux. On comprend que la structure de paroi externe soit ainsi nettement plus légère que dans les structures connues dans lesquelles la totalité de la paroi doit être pratiquement indéformable. On peut ainsi réaliser, à moindre frais, une machine sous vide de grandes dimensions, dont le diamètre peut excéder cinq mètres, et par laquelle le positionnement des appareillages peut être très précis, selon une précision de l'ordre de quelques centièmes de millimètres.

Cette forme particulière de paroi externe en voûte et de montants latéraux incurvés permet de libérer un volume interne maximum pour contenir la pièce sur laquelle on veut effectuer les travaux. En particulier, la forme incurvée des montants latéraux permet de disposer des montants dont la section est d'égale résistance, présentant donc une grande rigidité pour assurer une bonne précision de positionnement des appareillages, alors que la plus grande partie de matière constituant la section des montants est reportée latéralement à proximité de la paroi externe, c'est-à-dire que la matière formant les montants est placée au maximum dans une zone non utilisée pour le passage des appareillages.

Selon un mode de réalisation, la partie inférieure de paroi externe comprend une base plane et une surface supérieure concave de laquelle dépassent des nervures longitudinales sur lesquelles reposent les supports internes de pièce et d'outillage, lesdites nervures longitudinales étant supportées par des montants rigides, l'ensemble formant une pièce rigide solidaire. Eventuellement, cette pièce rigide solidaire peut être constituée de l'assemblage de deux ou plusieurs pièces assemblées sur le site et construites chacune en atelier.

Les poutres maintenues verticales présentent avantageusement un profil intérieur rectiligne vertical formant guide pour la poutre horizontale, et un profil extérieur incurvé épousant sensiblement la courbure des montants latéraux. Cette forme permet d'augmenter également la rigidité desdites poutres verticales, pour améliorer la précision de positionnement des appareillages, sans pour autant réduire l'espace intermédiaire compris entre lesdites poutres verticales pour le déplacement des appareillages.

Un mode de réalisation particulièrement avantageux de l'invention consiste à utiliser comme support des mouvements de l'outillage deux montants généralement verticaux, chacun en forme de coque constituée de plaques incurvées, limités chacun par un bord supérieur sensiblement horizontal, un bord inférieur sensiblement horizontal, un bord postérieur sensiblement vertical et un bord antérieur sensiblement vertical. Les bords postérieurs sont reliés par des poutres obliques croisées. On réalise ainsi une structure porteuse très rigide, et, par répartition de matière selon la longueur des montants, la structure permet de diminuer leur épaisseur et l'encombrement desdits montants, libérant au maximum l'espace interne de l'enceinte.

Ainsi, la structure selon l'invention autorise une déformabilité maximum des parois de l'enceinte, et minimise ainsi les coûts de fabrication en diminuant les sections.

La structure diminue en outre les facteurs de salissure dés parois, et en autorise un nettoyage facile.

La structure rend également très aisé l'accès aux appareils.

Un autre intérêt de la structure est de permettre l'extraction complète des supports d'appareillages et des supports de pièces, permettant un nettoyage complet de l'enceinte.

D'autres objets, caractéristiques et avantages de la présente invention ressortiront de la description suivante de modes de réalisation particuliers, faite en relation avec les figures jointes parmi lesquelles :

– la figure 1 est une coupe transversale d'une machine selon un premier mode de réalisation de la présente invention ;

– la figure 2 est une coupe longitudinale de la machine de la figure 1 ;

– la figure 3 est une coupe transversale d'une machine selon un second mode de réalisation de l'invention ; et

– la figure 4 est une coupe longitudinale de la machine de la figure 3.

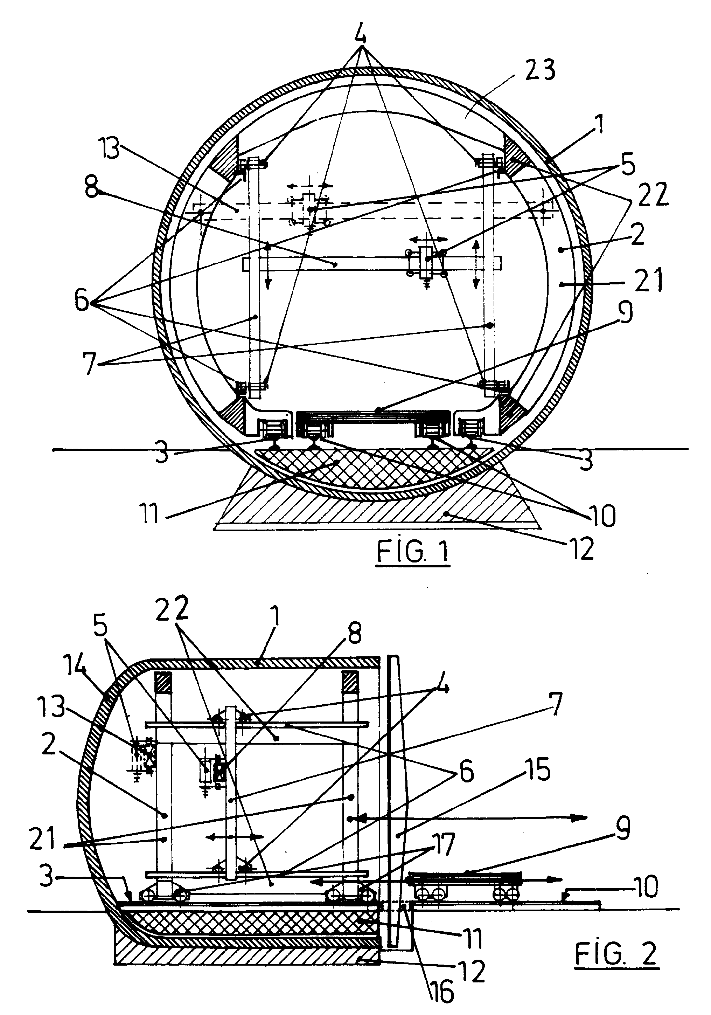

Dans le mode de réalisation représenté sur les figures 1 et 2, la machine sous vide selon la présente invention comprend une paroi externe 1 métallique de forme cylindrique ou similaire, d'axe horizontal, définissant une enceinte étanche, fermée d'un côté par un fond 14 et de l'autre par une porte 15 d'accès permettant de l'obturer de manière étanche.

La partie basse de paroi externe cylindrique repose sur un berceau 12, de préférence intégré à la structure de paroi, assurant la stabilité de l'ensemble et le report des charges aux fondations.

La paroi interne de l'enceinte est lisse et continue. Les seuls accidents importants de cette continuité sont les orifices des tuyaux de pompage ou pénétration de fluides divers, non représentés sur les figures.

Un contre berceau 11 est positionné en vis à vis du berceau 12, contre la face interne de paroi externe 1, dans sa zone inférieure, comme le représente la figure. Le berceau 12 peut simplement reposer sur la face inférieure de paroi externe 1, ou être lié à la paroi par des moyens de fixation empêchant son glissement.

Sur ce contre berceau 12 viennent se fixer deux paires de rails 3 et 10 parallèles à l'axe du cylindre. Ces deux paires de rails disposent de leur continuation extérieure devant la porte, un système classique 16 interrompant ou rétablissant la continuité des rails selon la position fermée ou ouverte de la porte.

Le support interne de pièce 9 est formé d'un chariot porte-pièces roulant sur la paire de rails 10. Sur la figure 1, le chariot porte-pièces 9 est représenté en position "opération sur la pièce" à l'intérieur de l'enceinte. Sur la figure 2, le chariot porte-pièces 9 est représenté en position "chargement-déchargement" à l'extérieur de l'enceinte.

Le support interne d'appareillage 2 comprend un portique épousant la forme de la paroi interne 1, à une faible distance de la face interne de celle-ci. Son profil adopte ainsi une forme en arc de cercle, les deux extrémités inférieures de l'arc étant conformées pour reposer sur la paire de rails 3, ou pour rouler sur celle-ci.

Dans la forme de configuration représentée sur les figures 1 et 2, le support interne d'appareillage 2, en forme de portique à deux arches, comprend quatre montants généralement verticaux 21 reliés deux à deux par des traverses supérieures incurvées 23, les montants 21 et les traverses 23 épousant la courbure de partie supérieure d'enceinte, les montants verticaux étant en outre reliés deux par deux par des traverses longitudinales 22, de préférence deux traverses supérieures et deux traverses inférieures comme le représentent les figures.

Dans un mode de réalisation particulier, représenté sur la figure 2, quatre chariots motorisés 17 assurent le déplacement du portique 2 sur les rails 3.

Dans un mode de réalisation simplifié, représenté sur les figures 1 et 2 en pointillés, une poutre horizontale transversale 13 est fixée sur un portique 2 à une seule arche. Sur cette poutre, circule un chariot support d'appareillage 5. Cette configuration permet un déplacement transversal de l'appareillage.

Dans un mode de réalisation plus complet, permettant un déplacement très précis de l'appareillage selon la plus grande partie du volume de l'enceinte, quatre rails 6 sont positionnés longitudinalement entre les montants 21, parallèlement à l'axe du cylindre, par exemple fixés aux traverses longitudinales 22. Le long de ces quatre rails 6 circulent quatre chariots 4 munis de moyens d'entraînement asservis par des moyens électroniques ou mécaniques, non représentés sur les figures, de sorte que les quatre chariots 4 se déplacent en restant en permanence dans un même plan transversal commun, le long de leurs rails respectifs. Les chariots 4 sont assujettis en bout de deux poutres verticales 7 disposées latéralement dans l'enceinte, de sorte que, lors du déplacement des chariots 4, les deux poutres 7 sont maintenues verticales et dans le même plan transversal commun.

Le long de ces deux poutres verticales 7 vient coulisser par ses extrémités une poutre horizontale 8, sollicitée par des organes d'entraînement, et équipée d'un chariot mobile 5 supportant les appareillages.

Ce dispositif permet le déplacement des appareillages dans les trois dimensions à l'intérieur de l'enceinte.

Dans ce mode de réalisation dans lequel les portiques 21 sont montés sur des chariots 17, l'ensemble du support interne d'appareillage peut être sorti hors de l'enceinte pour le nettoyage de l'enceinte.

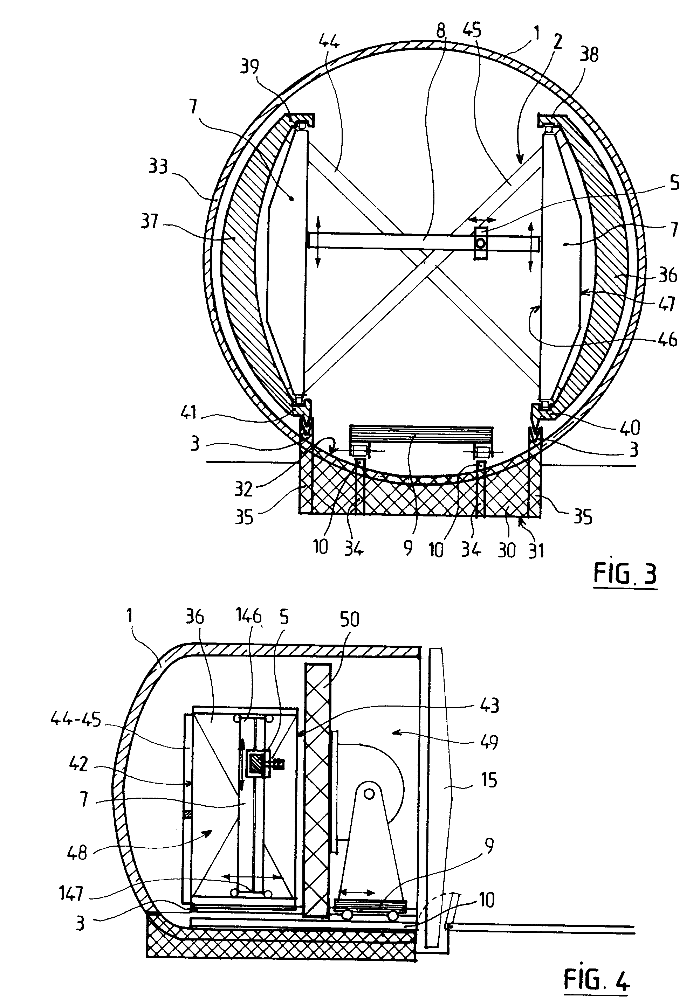

On a représenté sur les figures 3 et 4 un mode de réalisation plus évolué d'une machine à vide de grandes dimensions selon l'invention. Les parties similaires de celles du mode de réalisation des figures 1 et 2 ont été répertoriées par les mêmes références numériques. On retrouve ainsi la paroi externe 1, à section transversale arrondie en voûte, par exemple à section circulaire. Toutefois la paroi externe 1 se distingue par le fait qu'elle comprend une partie inférieure 30 rigide, qui constitue une base d'appui commune pour le support interne de pièce 9 et pour le support interne d'appareillage 2. La partie inférieure 30 comprend une face inférieure externe 31 constituant la face inférieure d'appui de la machine, sa face supérieure interne 32 constituant la base d'appui des supports de pièces et d'appareillage. La rigidité de la partie inférieure 30 de paroi externe rend négligeables toutes déformations de ladite partie inférieure lors des variations de contraintes de pression dues au vide à l'intérieur de l'enceinte.

La partie restante 33 de paroi externe 1 se raccorde de manière étanche à ladite partie inférieure, par exemple par soudure le long des bords de la partie inférieure 30.

Les supports internes de pièce 9 et d'outillage 2 sont en contact de la seule partie inférieure 30 de paroi externe, à l'exclusion de tout contact avec la partie restante 33 de paroi externe.

Dans le mode de réalisation représenté, la partie inférieure 30 de paroi externe comprend une base plane 31 et une surface supérieure 32 concave de laquelle dépassent des nervures longitudinales formant les rails 10 et 3 sur lesquels reposent les supports internes de pièce 9 et d'outillage 2. Les nervures longitudinales formant les rails 10 et 3 sont supportées par des montants rigides, à savoir les montants 34 pour les rails 10 et les montants 35 pour les rails 3, l'ensemble formant une pièce rigide solidaire.

Le support 2 d'appareillage comprend deux montants généralement verticaux 36 et 37, en forme de coque comprenant des plaques incurvées, limités chacun par un bord supérieur horizontal 38 et 39, par un bord inférieur horizontal 40 et 41, par un bord postérieur 42 sensiblement vertical, et par un bord antérieur 43 sensiblement vertical. Les bords postérieurs 42 sont reliés par des poutres obliques croisées 44 et 45.

Les bords supérieurs 38 et 39 et les bords inférieurs 40 et 41 des montants 36 et 37 sont conformés en rails pour le guidage de chariots. Deux chariots 146 et 147 à commande synchrone se déplacent respectivement sur les rails formés par le bord supérieur 38 et le bord inférieur 40 du montant 36, et sont reliés par une poutre 7 maintenue verticale par le déplacement synchrone des chariots. De même, une poutre similaire 7 est maintenue en position verticale et portée par des chariots coulissant dans les rails formés sur les bords 39 et 41 du second montant 37.

Une poutre horizontale 8, sollicitée par des organes d'entraînement, coulisse par ses extrémités sur les deux poutres 7 maintenues verticales, et est équipée d'un chariot mobile 5 portant les appareillages.

Les poutres maintenues verticales 7 présentent un profil intérieur rectiligne vertical, par exemple le profil 46, formant guide de la poutre horizontale 8, et un profil extérieur incurvé tel que le profil 47 (épousant sensiblement la courbure des montants latéraux 36 et 37.

Dans le mode de réalisation représenté sur la figure 4, les montants verticaux 36 et 37 en forme de coque ont une longueur égale à une fraction de la longueur de la paroi externe 1, définissant une première partie 48 d'enceinte dans laquelle une pièce peut être logée entre les coques 36 et 37 et les poutres verticales 7 pour les travaux à effectuer sur toutes ses faces, et définissant une seconde partie 49 d'enceinte dans laquelle une pièce de plus grande dimension peut être insérée pour un travail frontal. Par exemple, on a représenté sur la figure 4 une pièce 50, disposée dans la seconde partie 49, et supportée par le support de pièce 9, la pièce 50 présentant une section seulement légèrement inférieure à la section transversale de la paroi externe 1.

Une telle structure présente l'avantage de pouvoir être réalisée par étapes successives, la plupart des étapes pouvant être effectuées en atelier, éventuellement en un lieu très éloigné du lieu du chantier sur lequel doit être placée la machine.

Pour cela, on réalise ou on assemble sur le chantier lui-même seulement la partie inférieure 30 de paroi externe, puis on soude à ladite paroi inférieure 30 la partie restante 33 de paroi externe. On introduit ensuite le support d'appareillage 2 et le support de pièce 9. Le support d'appareillage 2 a pu être préalablement entièrement monté et testé en usine.

Dans les modes de réalisation dans lesquels le support de pièce 9 est un chariot roulant sur des rails longitudinaux 10, on peut avantageusement, pour introduire ou déplacer le support d'appareillage 2, utiliser les mêmes rails 10 sur lesquels roule un chariot portant le support d'appareillage. Il suffit d'adapter des moyens de levage entre ledit chariot et le support d'appareillage.

**Revendications**

1. Machine sous vide, pour travaux sous vide et notamment par faisceaux d'électrons, comportant :
   – une paroi externe (1) définissant une enceinte étanche munie d'une porte d'accès (15),
   – un support interne de pièce (9), destiné à supporter une pièce sur laquelle on veut effectuer les travaux,

– un support interne d'appareillage (2) pour supporter et positionner un ou plusieurs appareils assurant les travaux sur la pièce, le support d'appareillage (2) comprenant des montants latéraux supportant des rails longitudinaux (6, 38-41) sur lesquels circulent des chariots (4, 146, 147) portant deux poutres (7) maintenues verticales,

– une poutre horizontale (8) coulissant par ses extrémités sur les poutres (7) maintenues verticales, et équipée d'un chariot mobile (5) supportant les appareillages,

– une partie inférieure (30) rigide de paroi externe (1) comportant une face supérieure interne (32) constituant une base d'appui commune pour le support interne de pièce (9) et le support interne d'appareillage (2), et comportant une face inférieure externe (31) constituant la surface inférieure d'appui de la machine,

caractérisée en ce que :

– la partie restante (33) de la paroi externe présente une forme cylindrique de section transversale arrondie en voûte,

– la partie restante (33) de paroi externe (1) présente une résistance plus réduite et se raccorde de manière étanche à ladite partie inférieure (30),

– les supports internes de pièce (9) et d'outillage (2) sont en contact de la seule partie inférieure (30) de paroi externe, à l'exclusion de tout contact avec la partie restante (33) de paroi externe,

– les montants latéraux (21, 36, 37) sont incurvés et épousent sensiblement la forme interne de paroi externe (1).

2. Machine selon la revendication 1, caractérisée en ce que la partie inférieure (30) de paroi externe comprend une base plane (31) et une surface supérieure (32) concave de laquelle dépassent des nervures longitudinales (3, 10) sur lesquelles reposent les supports internes de pièce (9) et d'outillage (2), lesdites nervures longitudinales (3, 10) étant supportées par des montants rigides (35, 34), l'ensemble formant une pièce rigide solidaire.

3. Machine selon l'une des revendications 1 ou 2, caractérisée en ce que les poutres maintenues verticales (7) présentent un profil intérieur (46) rectiligne formant guide de la poutre horizontale (8), et un profil extérieur (47) incurvé épousant sensiblement la courbure des montants latéraux (36, 37).

4. Machine selon l'une quelconque des revendications 1 à 3, caractérisée en ce qu'elle comprend quatre montants verticaux (21) reliés deux à deux par une traverse supérieure incurvée (23) épousant la courbure de partie supérieure d'enceinte et reliés par les rails longitudinaux (6).

5. Machine selon l'une quelconque des revendications 1 à 3, caractérisée en ce que :

– elle comprend deux montants verticaux (36, 37) en forme de coques limités chacun par un bord supérieur (38, 39) sensiblement horizontal, un bord inférieur (40, 41) sensiblement horizontal, un bord postérieur (42) sensiblement vertical et un bord antérieur (43) sensiblement vertical,

– les bords postérieurs (42) sont reliées par des poutres obliques croisées (44, 45).

6. Machine selon la revendication 5, caractérisée en ce que les montants verticaux (36, 37) ont une longueur égale à une fraction de la longueur de paroi externe (1), définissant une première partie d'enceinte (48) dans laquelle une pièce peut être logée entre les montants latéraux et les poutres verticales pour les travaux à effectuer sur toutes ses faces, et définissant une seconde partie d'enceinte (49) dans laquelle une pièce de plus grande dimension (50) peut être insérée pour un travail frontal.

7. Machine selon l'une des revendications 5 ou 6, caractérisée en ce que les bords supérieurs (38, 39) et inférieurs (40, 41) de chaque montant (36, 37) sont conformés en rails pour le guidage de deux chariots (146, 147) à commande synchrone se déplaçant sur les rails et reliés par une poutre verticale (7).

8. Procédé de réalisation d'une machine sous vide selon l'une quelconque des revendications 1 à 7, caractérisé en ce qu'il comprend les étapes suivantes :

– réaliser ou assembler sur chantier la partie inférieure (30) de paroi externe,

– souder à ladite partie inférieure (30) de paroi externe la partie restante (33) de paroi externe,

– introduire le support d'appareillage (2) préalablement monté et testé,

– introduire le support de pièce (9).

9. Procédé selon la revendication 8, caractérisé en ce que, pour introduire ou déplacer le support d'appareillage (2) on place ledit support d'appareillage (2) sur un chariot roulant sur des rails (10) longitudinaux destinés à supporter un chariot formant support de pièce (9).

**Claims**

1. A vacuum machine, for operations under vacuum and more particularly by means of electron beams, comprising ;

– an external wall (1) defining a sealed enclosure fitted with an access door (15);

– an internal workpiece holder (9), intended to support a workpiece upon which it is intended to carry out work,

– an internal tool holder (2) for supporting and positioning one or more tools for effecting work on the workpiece, said tool holder (2) comprising lateral uprights carrying longitudinal rails (6, 38-41) upon which there move carriages (4, 146, 147) bearing girders (7) which are kept vertical,

– a horizontal girder (8) sliding on its ends on the girders (7) which are kept upright, and equipped with a mobile carriage (5) carrying the tools,
– a rigid lower portion (30) of the external wall (1), comprising an upper internal face (32) forming a common support base for the internal workpiece holder (9) and the internal tool holder (2), and comprising a lower external face (31) forming the lower support surface of the machine,
characterised in that:
    – the remaining portion (33) of the external wall is of cylindrical shape, with a rounded and arched cross-section,
    – the remaining portion (33) of the external wall (1) is of reduced strength , and is connected in a sealed manner to the said lower portion (30),
    – the internal workpiece holder (9) and tool holder (2) are in contact with the single lower portion (30) of the external wall, excluding all contact with the remaining portion (33) of the external wall,
    – the lateral uprights (21, 36, 37) are incurvated, substantially conforming to the internal shape of the external wall (1).

2. A machine according to Claim 1, characterised in that the lower portion (30) of the external wall comprises a planar base (31) and an upper concave surface (32) from which there originate longitudinal ribs (3, 10) on which there rest the internal workpiece (9) and tool holders (2), said longitudinal ribs (3, 10) being supported by rigid uprights (35, 34), the whole forming a rigid integral component.

3. A machine according to Claims 1 or 2, characterised in that the girders kept vertical (7) have a rectilinear internal profile (46) forming a guide for the horizontal girder (8), and an incurvated external profile (47) substantially conforming to the curvature of the lateral uprights (36, 37).

4. A machine according to any one of Claims 1 to 3, characterised in that it comprises four vertical uprights (21) connected in pairs by an upper incurvated crosspiece (23) conforming to the curvature of the upper portion of the enclosure, and connected by longitudinal rails (6).

5. A machine according to any one of Claims 1 to 3, characterised in that:
    – it comprises two vertical shell-shaped uprights (36, 37) each limited by a substantially horizontal upper edge (38, 39), a substantially horizontal lower edge (40, 41), a substantially vertical posterior edge (42) and a substantially vertical anterior edge (43),
    – the posterior edges (42) being connected by crossed oblique girders (44, 45).

6. A machine according to Claim 5, characterised in that the vertical uprights (36, 37) are of a length equal to a fraction of the length of the external wall (1), defining a first enclosure portion (48) in which a workpiece may be fixed between the lateral uprights and the vertical girders for the work to be carried out on all its surfaces, and defining a second enclosure portion (49) into which a workpiece of larger dimensions (50) may be inserted for frontal work.

7. A machine according to one of Claims 5 or 6, characterised in that the upper (38, 39) and lower edges (40, 41) of each upright (36, 37) are formed into rails for guiding two synchronously-controlled carriages (146, 147) which move on the rails and are connected by a vertical girder (7).

8. A method of manufacturing a vacuum machine according to any one of Claims 1 to 7, characterised in that it comprises the following stages:
    – manufacturing or assembling on site the lower portion (30) of the external wall,
    – brazing to the said lower portion (30) of the external wall the remaining portion (33) of the external wall,
    – introducing the tool holder (2), which has been previously assembled and tested,
    – introducing the workpiece holder (9).

9. A method according to Claim 8, characterised in that, in order to introduce or move the tool holder (2), said tool holder (2) is placed on a carriage running on longitudinal rails (10) intended to carry a carriage forming a workpiece holder (9).

## Patentansprüche

1. Maschine unter Vakuum, für Arbeiten unter Vakuum und insbesondere mit Elektronenstrahlen, bestehend aus:
    – einer Außenwand (1), die eine dichte Umfassung ergibt und mit einer Einlaßtür (15) versehen ist,
    – einer inneren Werkstückauflage (9), die für ein Tragen eines Werkstückes bestimmt ist, an welchem man die Arbeiten ausüben möchte,
    – einer inneren Geräteauflage (2) für ein Tragen und Positionieren eines oder mehrerer Geräte, welche die Arbeiten an dem Werkstück sicherstellen, wobei die Geräteauflage (2) seitliche Träger aufweist, die Längsschienen (6, 38-41) tragen, auf welchen Schlitten (4, 146, 147) laufen, die zwei vertikal ausgerichtete Träger (7) halten,
    – einem Horizontalträger (8), der mit seinen Enden an den vertikal ausgerichteten Trägern (7) verschieblich geführt und mit einem beweglichen Schlitten (5) ausgerüstet ist, welcher die Geräte trägt,
    – einem starren Unterteil (30) der Außenwand (1), der eine obere Innenfläche (32) aufweist, welche eine gemeinsame Fußstütze für die innere Werkstückauflage (9) und für die innere Geräteauflage (2) ausbildet, und eine untere Außenfläche (31) aufweist, welche die untere Stützfläche der Maschine ausbildet,
dadurch gekennzeichnet, daß:
    – der Restteil (33) der Außenwand eine im Querschnitt runde und nach außen gewölbte Zylinderform aufweist,

– der Restteil (33) der Außenwand einen weiter verringerten Widerstand aufweist und sich an den Unterteil (30) eng anschließt,

– die inneren Werkstück- und Geräteauflagen (9, 2) mit dem einzigen Unterteil (30) der Außenwand in Berührung sind, unter Ausschluß jeder Berührung mit dem Restteil (33) der Außenwand,

– die seitlichen Träger (21, 36, 37) gekrümmt sind und sich im wesentlichen der Innenform der Außenwand (1) anpassen.

2. Maschine nach Anspruch 1, dadurch gekennzeichnet, daß der Unterteil (30) der Außenwand eine ebene Grundfläche (31) und eine konkave obere Fläche (32) aufweist, welche von Längsrillen (3, 10) überragt ist, auf denen die inneren Werkstück- und Geräteauflagen (9, 2) ruhen, wobei die Längsrillen (3, 10) durch starre Stützen (35, 34) abgestützt sind und die Gesamtheit ein starres formschlüssiges Teil ausbildet.

3. Maschine nach Anspruch 1 oder 2, dadurch gekennzeichnet, daß die vertikal ausgerichteten Träger (7) ein geradliniges Innenprofil (46) aufweisen, welches eine Führung für den Horizontalträger (8) ausbildet, und ein gekrümmtes Außenprofil (47), welches im wesentlichen der Krümmung der seitlichen Träger (36, 37) angepaßt ist.

4. Maschine nach einem der Ansprüche 1 bis 3, dadurch gekennzeichnet, daß sie vier vertikale Träger (21) aufweist, die paarweise durch einen oberen gekrümmten Querträger (23) verbunden sind, dessen Krümmung an den Oberteil der Umfassung angepaßt ist, und die durch die Längsschienen (6) verbunden sind.

5. Maschine nach einem der Ansprüche 1 bis 3, dadurch gekennzeichnet, daß:

– sie zwei vertikale Träger (36, 37) in der Ausbildung von Schalen aufweist, welche jeweils durch einen im wesentlichen horizontalen oberen Rand (38, 39), einen im wesentlichen horizontalen unteren Rand (40, 41), einen im wesentlichen vertikalen hinteren Rand (42) und einen im wesentlichen vertikalen vorderen Rand (43) begrenzt sind,

– die hinteren Ränder (42) durch sich kreuzende schräge Träger (44, 45) verbunden sind.

6. Maschine nach Anspruch 5, dadurch gekennzeichnet, daß die vertikalen Träger (36, 37) eine Länge gleich einem Bruchteil der Länge der Außenwand (1) aufweisen, die einen ersten Umfassungsteil (48) bestimmt, innerhalb von welchem ein Werkstück zwischen den seitlichen Trägern und den vertikalen Trägern angeordnet werden kann, um die Arbeiten an allen seinen flächen ausführen zu können, und einen zweiten Umfassungsteil (49) bestimmt, innerhalb von welchem ein Werkstück (50) größerer Abmessungen für eine vordere Bearbeitung eingesetzt werden kann.

7. Maschine nach Anspruch 5 oder 6, dadurch gekennzeichnet, daß die oberen Ränder (38, 39) und die unteren Ränder (40, 41) jedes Trägers (36, 37) als Führungsschienen für zwei synchron gesteuerte Schlitten (146, 147) ausgebildet sind, die auf den Schienen laufen, und durch einen vertikalen Träger (7) verbunden sind.

8. Verfahren zur Herstellung einer Maschine unter Vakuum nach einem der Ansprüche 1 bis 7, dadurch gekennzeichnet, daß es die folgenden Schritte umfaßt:

– Herstellung oder Zusammenbau an einem Montageort des Unterteils (30) der Außenwand,

– Verschweißung des Restteils (33) der Außenwand mit diesem Unterteil (30) der Außenwand,

– Einfügung der zuvor montierten und geprüften Geräteauflage (2),

– Einfügung der Werkstückauflage (9).

9. Verfahren nach Anspruch 8, dadurch gekennzeichnet, daß zur Einfügung oder Ortsveränderung der Geräteauflage (2) die Geräteauflage (2) auf einem auf den Längsschienen (10) laufenden Schlitten angeordnet wird, welche zum Tragen eines die Werkstückauflage (9) bildenden Schlittens bestimmt sind.

FIG. 1

FIG. 2

FIG. 3

FIG. 4